# EUROPEAN PATENT APPLICATION

(11) **EP 2 423 691 A2**
(43) Date of publication of application: **29.02.2012**
(21) Application number: 11173405.9
(22) Date of filing: 11.07.2011
(51) Int. Cl.: G01R 13/02

(54) **Re-Sampling Acquired Data to Prevent Coherent Sampling Artifacts**

(30) Priority: 27.08.2010 US 377856 P; 13.04.2011 US 86228
(71) Applicant: Tektronix, Inc., Beaverton, Oregon 97077-0001 (US)
(72) Inventor: Eby, David, Aloha, OR Oregon 97007 (US)
(74) Representative: Clarke, Jeffrey

(57) **Abstract**

Embodiments of the present invention provide a test and measurement instrument that processes acquired data before it is displayed by re-sampling it with a pseudo-random sampling phase (510,515,540). This data processing step introduces a randomly-varying phase between the signal under test and the sampling clock of the test and measurement instrument, thereby canceling the effect of any synchronization between the two. In this manner, the test and measurement instrument may acquire data based on a clock signal that is very close to, or even synchronized with, the test and measurement instrument's own sampling clock (or a harmonic of it), and yet still provide a smooth, artifact-free display.

## Description

### FIELD OF THE INVENTION

The present invention relates to test and measurement instruments, and more particularly to methods of displaying acquired data.

### BACKGROUND OF THE INVENTION

Real-time spectrum analyzers such as the RSA6100 and RSA3400 families available from Tektronix, Inc. of Beaverton, Oregon trigger on, capture, and analyze RF signals in real-time. These test and measurement instruments seamlessly capture RF signals so that, unlike conventional swept spectrum analyzers and vector signal analyzers, no data is missed within a specified bandwidth.

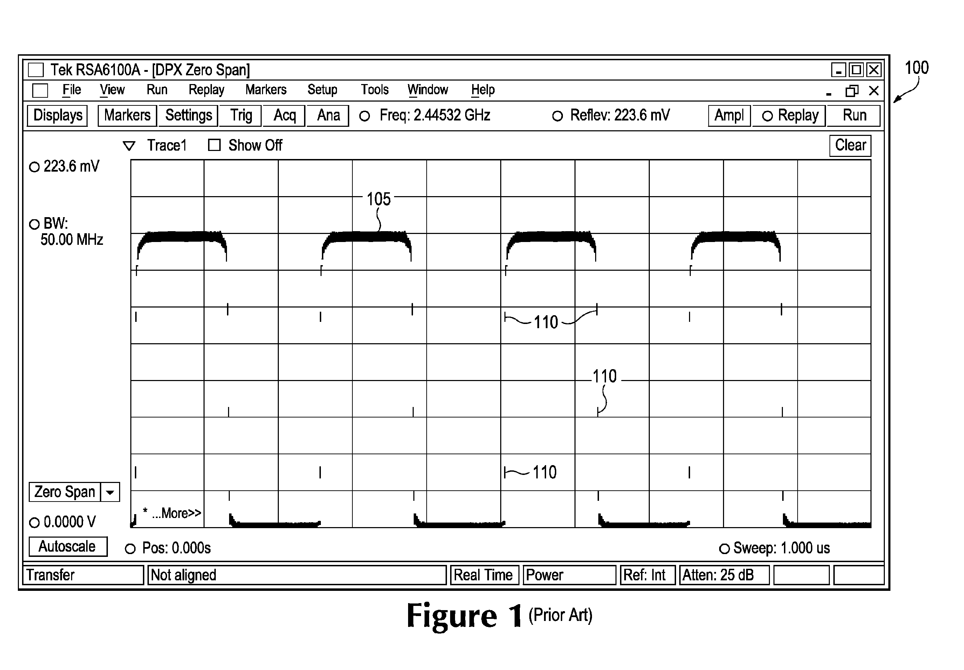

In some cases, a real-time spectrum analyzer is used to measure a signal under test that is generated based on a clock signal that is very close to, or even synchronized with, the sampling clock of the real-time spectrum analyzer itself (or a harmonic of it). In such cases, "coherent sampling" occurs, and as a result, the displayed waveform can contain various objectionable artifacts. For example, FIG. 1 shows a time-domain display of a pulsed RF signal 105 in which, due to this effect, samples only appear at a few locations 110 on the rising and falling edges of the waveform.

What is desired is a way of providing a smooth, artifact-free display when the signal under test is very close to, or even synchronized with, the sampling clock of the real-time spectrum analyzer.

### SUMMARY OF THE INVENTION

Embodiments of the present invention provide a test and measurement instrument that processes acquired data before it is displayed by re-sampling it with a pseudo-random sampling phase. This data processing step introduces a randomly-varying phase between the signal under test and the sampling clock of the test and measurement instrument, thereby canceling the effect of any synchronization between the two. In this manner, the test and measurement instrument may acquire data based on a clock signal that is very close to, or even synchronized with, the test and measurement instrument's own sampling clock (or a harmonic of it), and yet still provide a smooth, artifact-free display.

The objects, advantages, and other novel features of the present invention are apparent from the following detailed description when read in conjunction with the appended claims and attached drawings.

### BRIEF DESCRIPTION OF THE DRAWINGS

FIG. 1 depicts a conventional time-domain display of a pulsed RF signal.

FIG. 2 depicts a high-level block diagram of a real-time spectrum analyzer.

FIG. 3 illustrates how digital data is processed according to an embodiment of the present invention.

FIG. 4 depicts the waveform of FIG. 1 after being processed according to the present invention.

FIG. 5 depicts a high-level block diagram of a re-sampler according to an embodiment of the present invention.

### DETAILED DESCRIPTION OF THE INVENTION

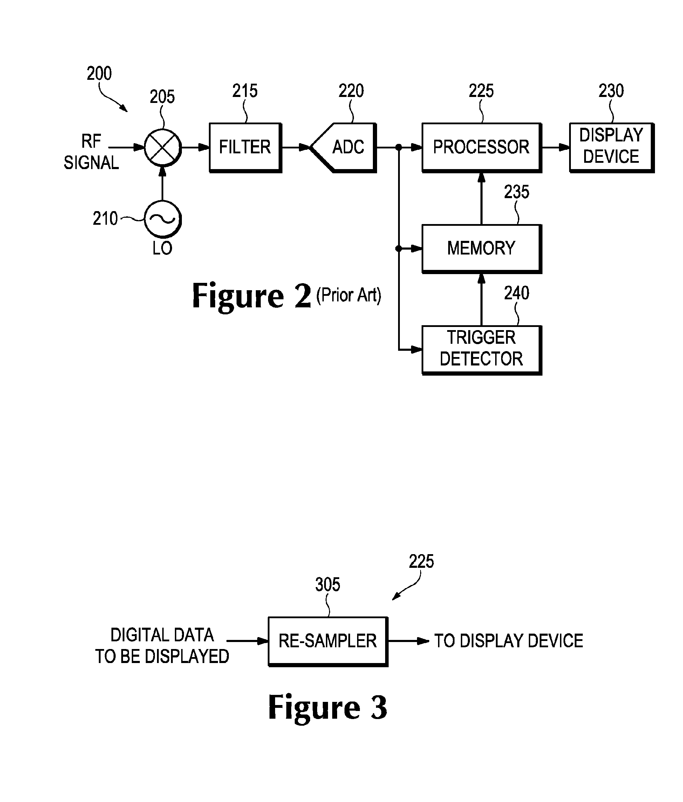

Referring now to FIG. 2, a conventional real-time spectrum analyzer 200 receives a radio frequency (RF) input signal and optionally down-converts it using a mixer 205, local oscillator (LO) 210, and filter 215 to produce an intermediate frequency (IF) signal. An analog-to-digital converter (ADC) 220 digitizes the IF signal in response to a sampling clock (not shown) to produce a continuous stream of digital data that represents the IF signal. The digital data is then processed in two paths. In the first path, the digital data is input to a processor 225 that analyzes the digital data in real-time. In the second path, the digital data is input to a memory 235 (which, in some embodiments, comprises a circular buffer) and also input to a trigger detector 240 that processes the digital data in real-time and compares the processed data to a user-specified trigger criterion. When the processed digital data satisfies the trigger criterion, the trigger detector 240 generates a trigger signal that causes the memory 235 to store a block of digital data. The processor 225 then analyzes the stored digital data. The processed digital data may be displayed on a display device 230 or stored in a storage device (not shown).

Now, in accordance with an embodiment of the present invention, the processor 225 processes the digital data before it is displayed by re-sampling it with a pseudo-random sampling phase. This data processing step introduces a randomly-varying phase between the signal under test and the sampling clock, thereby canceling the effect of any synchronization between the two. In this manner, the real time spectrum analyzer 200 may acquire data based on a clock signal that is very close to, or even synchronized with, the sampling clock (or a harmonic of it), and yet still provide a smooth, artifact-free display. This data processing step is illustrated graphically in FIG. 3, where a re-sampler 305 re-samples digital data before it is displayed.

The re-sampling may be accomplished in various different ways. For example, in one embodiment, the digital data is segmented into groups of samples referred to as "records," and all of the samples in each record are re-sampled based on a different pseudo-random phase value. That is to say, all of the samples in the first record are re-sampled based on a first pseudo-random phase value ϕ₁, all of the samples in the second record are re-sampled based on a second pseudo-random phase value ϕ₂, and so on. In another embodiment, the digital data is re-sampled on a sample-by-sample basis. That is to say, the first sample is re-sampled based on a first pseudo-random phase value ϕ₁, the second sample is re-sampled based on a second pseudo-random phase value ϕ₂, and so on. In either case, when the re-sampled samples are accumulated and displayed, the effect is a smooth, artifact-free display without any indication that the input signal is related in frequency to the sampling clock.

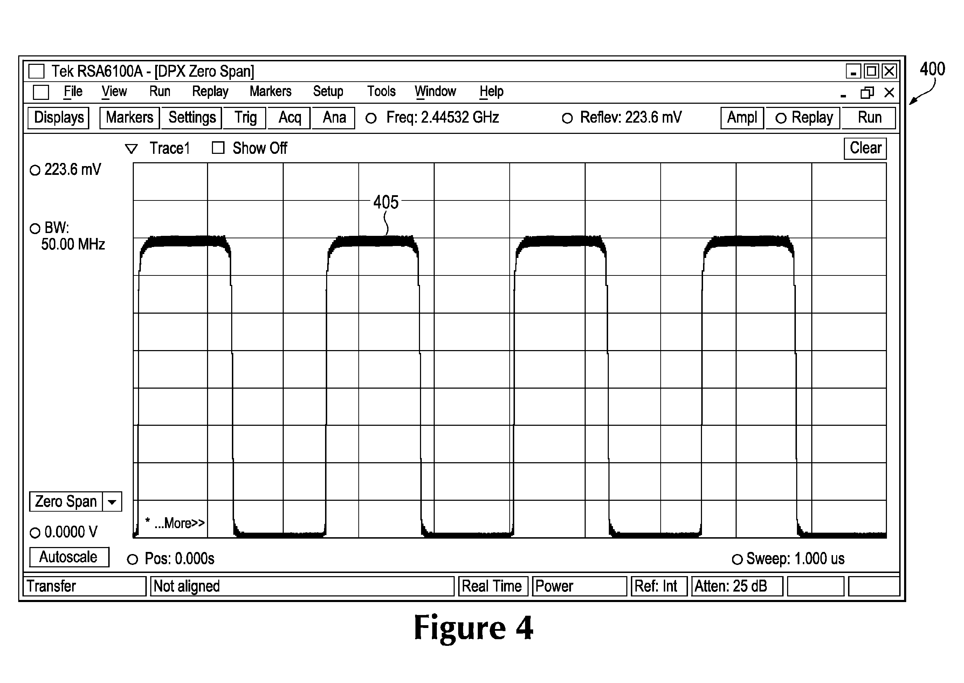

FIG. 4 shows the waveform of FIG. 1 after being processed as described above. Note that, unlike in FIG. 1 where samples only appear at a few locations 110 on the rising and falling edges of the waveform, the waveform of FIG. 4 is smooth and artifact-free.

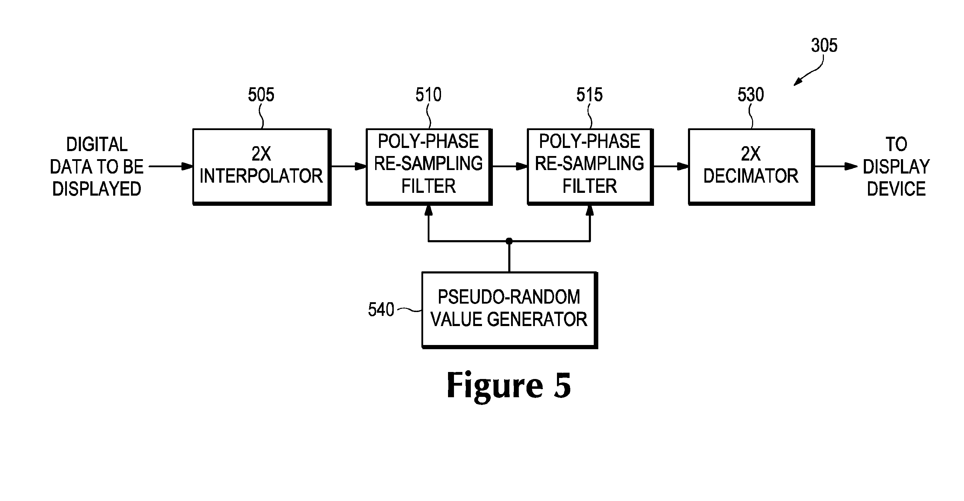

The re-sampling can be performed using any one of various techniques that are well known in the art. However, it will be appreciated that, in order to provide real-time processing (as required by the "first path" described above), the re-sampling must be performed in real-time. FIG. 5 depicts a high-level block diagram of one particular re-sampler 305 that is capable of operating in real-time. The digital data is first passed through a 2x interpolator 505, then through two poly-phase re-sampling filters 510 and 515, and then through a 2x decimator 530. A pseudo-random value generator 540 provides pseudo-random values which correspond to pseudo-random sampling phases to the poly-phase re-sampling filters 510 and 515. The purpose of the 2x interpolator 505 is to provide empty spectrum, thereby easing the filter roll-off requirements of the poly-phase re-sampling filters 510 and 515, thereby simplifying their design. As a result of the interpolation, each poly-phase re-sampling filter only provides one half of a clock cycle of phase shift, so two poly-phase re-sampling filters are needed to obtain a full clock cycle of phase shift. The purpose of the 2x decimator 530 is to restore the digital data to its original sample rate. Each of the poly-phase re-sampling filters 510 and 515 introduces a delay of 0 to 1 cycles of the 2x interpolated sampling clock, or 0 to 0.5 cycles of the sampling clock, for a total delay of 0 to 1 cycles of the sampling clock. In other embodiments, different interpolation ratios (i.e., other than 2x) and different numbers of poly-phase re-sampling filters (i.e., other than two) may also be used.

Although the present invention is described in terms of a real-time spectrum analyzer, it will be appreciated that the present invention may also be used in any other test and measurement instrument that digitizes a signal under test such as an oscilloscope and the like.

Any of the elements of the present invention that operate on digital data may be implemented in hardware, software, or a combination of the two, and may comprise and/or be performed on a general purpose microprocessor, a digital signal processor (DSP), an application specific integrated circuit (ASIC), a field-programmable gate array (FPGA), or the like.

It will be appreciated from the foregoing discussion that the present invention represents a significant advance in the field of test and measurement equipment. Although specific embodiments of the invention have been illustrated and described for purposes of illustration, it will be understood that various modifications may be made without departing from the scope of the invention. Accordingly, the invention should not be limited except as by the appended claims.

## Claims

1. A test and measurement instrument comprising:
a processor for re-sampling digital data with a pseudo-random sampling phase to produce processed digital data; and
a display device for displaying the processed digital data.

2. The test and measurement instrument of claim 1 wherein the processor processes the digital data before it re-samples it.

3. The test and measurement instrument of claim 1 wherein the processor re-samples the digital data by segmenting the digital data into records, and re-sampling all of the samples in each record based on a different pseudo-random phase value.

4. The test and measurement instrument of claim 1 wherein the processor re-samples the digital data on a sample-by-sample basis.

5. The test and measurement instrument of claim 1 wherein the processor comprises a poly-phase re-sampling filter.

6. The test and measurement instrument of claim 5 further comprising an interpolator for interpolating the digital data before it is applied to the poly-phase re-sampling filter.
